Europäisches Patentamt

European Patent Office

Office européen des brevets

(19)

(11) Numéro de publication : **0 181 801**
**B1**

(12) **FASCICULE DE BREVET EUROPÉEN**

(45) Date de publication du fascicule du brevet :
30.11.88

(51) Int. Cl.⁴ : **H 03 B   5/18**

(21) Numéro de dépôt : 85402047.6

(22) Date de dépôt : **22.10.85**

(54) Oscillateur à très hautes fréquences, à résonateurs gyromagnétiques.

(30) Priorité : 26.10.84 FR 8416374

(43) Date de publication de la demande :
21.05.86 Bulletin 86/21

(45) Mention de la délivrance du brevet :
30.11.88 Bulletin 88/48

(84) Etats contractants désignés :
DE GB IT NL SE

(56) Documents cités :
GB-A- 2 016 232
US-A- 3 879 677
IEEE INTERNATIONAL SOLID-STATE CIRCUITS
CONFERENCE, vol. 22, 15 février 1979, pages
162,163, IEEE, New York, US; Y. LE TRON et al.:
"Multioctave FET oscillators double tuned by a single
YIG"
1981 IEEE MTT-S INTERNATIONAL MICROWAVE
SYMPOSIUM DIGEST, 1981, pages 141,142, IEEE,
New York, US; J. OBREGON et al.: "Decade
bandwidth FET functions"

(73) Titulaire : THOMSON-CSF
173, Boulevard Haussmann
F-75379 Paris Cedex 08 (FR)

(72) Inventeur : Leiba, René
THOMSON-CSF SCPI 173, bld Haussmann
F-75379 Paris Cedex 08 (FR)

(74) Mandataire : Taboureau, James et al
THOMSON-CSF SCPI 19, avenue de Messine
F-75008 Paris (FR)

## Description

L'invention concerne un oscillateur à transistor à effet de champ, fonctionnant à très haute fréquence, et comportant deux résonateurs gyromagnétiques à billes de grenat d'yttrium, accordables électroniquement dans une très large gamme de fréquences, tout en possédant dans cette gamme une bonne linéarité de la fréquence en fonction du champ magnétique de commande des résonateurs. L'invention porte essentiellement sur le couplage des résonateurs avec la grille et la source du transistor à effet de champ.

Les oscillateurs de type triporte à transistors à effet de champ et résonateurs gyromagnétiques sont connus, mais jusqu'à présent ils jouissaient soit d'une large gamme de fréquence, soit d'une bonne linéarité. Selon les configurations, les réglages du ou des résonateurs à grenat d'yttrium ne permettaient, dans les montages connus, d'améliorer la gamme de fréquence qu'au prix d'une moins bonne linéarité, et réciproquement.

L'invention remédie à cet inconvénient en proposant un nouveau couplage entre les résonateurs et le transistor, qui résulte de l'analyse du fonctionnement de chaque résonateur en fonction de la fréquence. Chacun d'eux est, selon l'invention, couplé au transistor de façon à optimiser le régime d'oscillations vers les fréquences inférieures pour un résonateur et vers les fréquences supérieures pour l'autre résonateur. Par fréquences inférieures et supérieures, il faut entendre, dans le cadre de cette invention, des fréquences telles que 4 GHz et 22 GHz. L'oscillateur selon l'invention dispose alors d'une large gamme de fréquences, comprise entre 4 et 22 GHz tout en ayant une bonne linéarité dans cette gamme de fréquence, alors que les oscillateurs connus ne disposent que d'une plage comprise entre 7 et 14 GHz pour la même tolérance sur la linéarité de fréquences en fonction du champ de commande.

L'oscillateur selon l'invention comporte un transistor à effet de champ dont le drain est chargé par une impédance, par exemple une impédance normalisée à 50 ohms, dont la source est réunie à un dipôle d'accord, et dont la grille est réunie à un dipôle de réaction rebouclé sur la source à travers le dipôle d'accord. Les deux dipôles d'accord et de réaction sont constitués par des billes de grenat d'yttrium-fer ou de grenat de gallium-yttrium-fer. La première bille, dite de grille, dont l'influence sur la fréquence est prépondérante aux fréquences supérieures, est couplée par un fil à la grille. La seconde bille, couplée à la source par un fil, a une influence prépondérante aux fréquences inférieures. De façon à améliorer la linéarité aux fréquences inférieures, ce qui permet donc une plus grande excursion vers les fréquences inférieures, la seconde bille est doublement couplée, à la source comme il vient d'être dit par un fil, et à la grille par le même fil qui déjà couple la première bille.

De façon plus précise l'invention concerne un oscillateur à très hautes fréquences comportant un transistor à effet de champ, dont la source est réunie à un premier dipôle à résonateur gyromagnétique, la grille est réunie à un second dipôle à résonateur gyromagnétique et le drain est réuni à une impédance de charge, les deux résonateurs gyromagnétiques étant réglables simultanément par un même moyen électrique, cet oscillateur étant caractérisé en ce que :

- le premier résonateur est doublement couplé par un premier conducteur électrique connecté à la source du transistor et par un second conducteur électrique connecté à la grille du transistor,

- ledit second conducteur électrique est en outre doublement couplé au second résonateur.

L'invention sera mieux comprise par la description d'un exemple d'application, celui-ci s'appuyant sur les figures jointes en annexe qui représentent :

- figure 1 : schéma électrique d'un premier oscillateur à deux résonateurs selon l'art connu ;

- figure 2 : courbe donnant les conditions d'oscillations d'un oscillateur à deux résonateurs ;

- figure 3 : courbe de l'influence de l'anisotropie d'un résonateur sur la fréquence de résonance ;

- figure 4 : courbe montrant le rôle de chaque résonateur dans un oscillateur à deux résonateurs ;

- figure 5 : schéma électrique d'un second oscillateur à un seul résonateur selon l'art connu ;

- figure 6 : schéma électrique de l'oscillateur à deux résonateurs selon l'invention ;

- figure 7 : schéma électrique partiel de l'oscillateur selon l'invention, afin d'étudier l'effet du double couplage ;

- figure 8 : courbes d'impédance d'un résonateur doublement couplé et de l'impédance qu'il ramène sur le drain du transistor à effet de champ oscillateur ;

- figure 9 : courbe de l'écart de linéarité de l'oscillateur selon l'invention.

L'invention se rapporte aux oscillateurs électroniques à spectre étroit, hyperfréquence, accordables électroniquement dans une très large bande de fréquences. Parmi les oscillateurs hyperfréquences accordables électroniquement, ceux qui sont commandés par une tension, et connus sous le vocable VCO, ont une très large bande de fréquences, mais leur linéarité de fréquence en fonction de la tension de commande est mauvaise.

Les oscillateurs accordables par résonateurs gyromagnétiques tels que les grenats d'yttrium YIG ou les grenats de gallium-yttrium GaYIG ont des propriétés intéressantes : spectre étroit, large bande de fréquences, linéarité de la fréquence en fonction du champ magnétique H de commande du résonateur gyromagnétique. Mais, jusqu'à présent, ces oscillateurs ont soit une bande de fréquences relativement large et une linéarité qui n'est pas excellente, soit une bande de fréquences plus étroite et une excellente linéarité.

L'invention remédie à cet inconvénient en proposant un oscillateur qui ait à la fois une large bande de fréquences et une bonne linéarité dans toute cette bande de fréquence.

La fréquence d'oscillation d'un oscillateur est déterminée par la fréquence de résonance gyromagnétique des résonateurs qui se présentent sous forme de petites sphères ou billes de Yig ou de GaYIG : de façon à simplifier les explications qui viennent, on conviendra d'appeler bille de Yig les résonateurs gyromagnétiques de l'oscillateur de l'invention. La fréquence de résonance gyromagnétique F est directement proportionnelle au champ magnétique continu H appliqué sur les billes, selon la relation

$$F = aH$$

dans laquelle a est la pente de l'oscillateur.

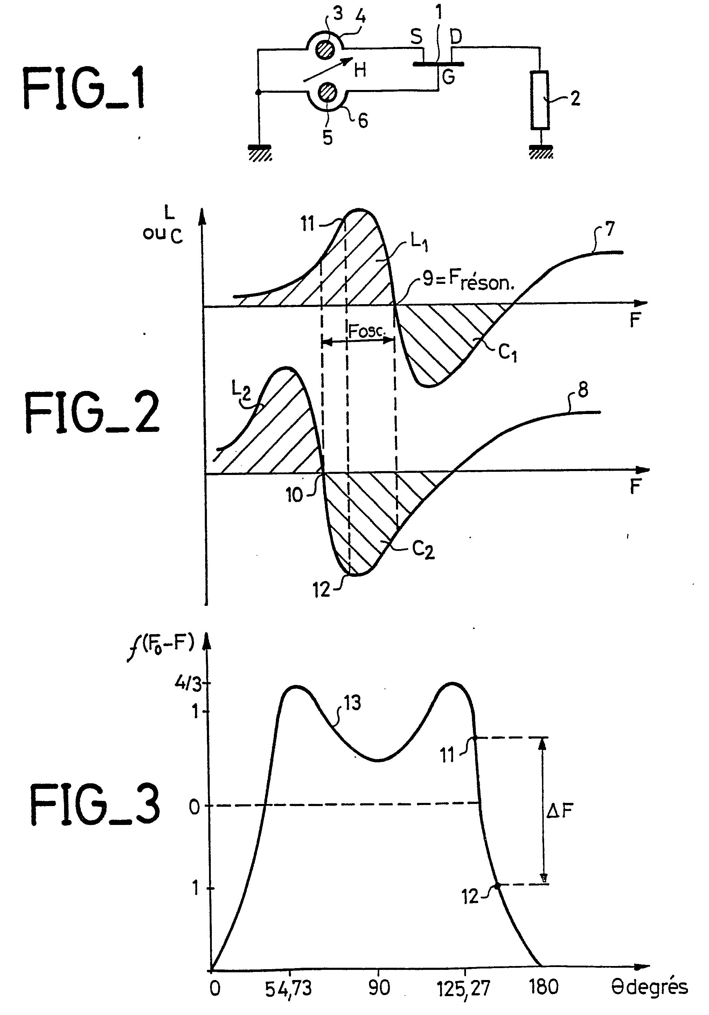

La figure 1 représente un oscillateur à billes de Yig, tel qu'il est décrit dans le brevet N° 78.06431, déposé le 7 mars 1978 au nom de la Demanderesse. Sur cette figure ne sont pas représentés les circuits d'alimentation du transistor à effet de champ 1, afin de simplifier le schéma électrique. Il en sera de même, dans la suite du texte, pour les autres schémas électriques d'oscillateurs.

Le transistor à effet de champ 1 de cet oscillateur a une sortie sur son drain D qui est chargé par une charge normalisée 2, qui est par exemple résistive à 50 ohms. Le dipôle d'accord est constitué par une bille de grenat d'yttrium 3 couplée par une demi boucle de fil 4 à la source du transistor à effet de champ. Le dipôle de réaction est constitué par une bille de grenat d'yttrium 5 couplée par une demi boucle de fil 6 à la grille du même transistor à effet de champ 1. Les deux billes 3 et 5 de Yig sont soumises au même champ magnétique H.

Ce dispositif oscille sous certaines conditions, qui sont connues et ont été établies au sujet des oscillateurs à résonateurs diélectriques, dont on rappellera seulement les conclusions principales :
- la somme des résistances ramenées sur le drain du transistor doit être inférieure ou égale à 0

$$\Sigma R \leqslant 0$$

- la somme des réactances ramenée sur le drain du transistor doit être nul

$$\Sigma X = 0.$$

En outre, et ceci est représenté par la figure 2, pour qu'il y ait oscillations, il faut qu'un résonateur soit selfique, pendant que l'autre résonateur est capacitif. La figure 2 représente, en fonction de la fréquence donnée en abscisse, la réactance selfique L ou capacitive C de deux billes de Yig, dont les variations sont représentées par les courbes 7 et 8. Pour une première bille de Yig, sa courbe de réactance 7 présente une partie selfique, appelée L1, puis au delà d'une certaine fréquence fixée par le point 9 une partie capacitive appelée C1. De même pour une deuxième bille de Yig correspondant à la courbe 8, sa courbe de réactance présente une partie selfique appelée L2 puis au delà du point 10 une partie capacitive appelée C2. Pour qu'un oscillateur comportant deux billes de Yig puisse fonctionner, il faut qu'une bille, par exemple celle correspondant à la courbe 7, présente une réactance selfique L1, pendant que l'autre bille, celle correspondant à la courbe 8 présente une réactance capacitive C2. Donc que les deux billes de Yig soient décalées en fréquence de résonance. La fréquence d'oscillation de l'oscillateur ainsi constitué est situé dans la plage de fréquence comprise entre les points 9 et 10, puisque c'est entre les abscisses de ces points qu'un résonateur est selfique tandis que l'autre est capacitif.

Si une première bille de Yig a une fréquence de résonance fixée par sa position dans le champ magnétique correspondant par exemple au point 11 sur la courbe 7, il faut que la seconde bille de Yig ait une fréquence de résonance correspondant au point 12 de la courbe 8, le point 12 ayant même abscisse en fréquence que le point 11.

La figure 3 représente la courbe d'influence de l'anisotropie d'un résonateur à Yig sur la fréquence de résonance. Le Yig est un matériau anisotrope, et sa fréquence de résonance est une fonction de l'orientation de son réseau cristallographique par rapport au champ magnétique H. Ainsi en figure 3 est représentée la courbe de réponse d'un résonateur à Yig, l'orientation de son réseau cristallin en degrés, par rapport à la direction du champ magnétique H, étant donnée en abscisse et une fonction de la fréquence d'oscillation étant donnée en ordonnée. La courbe de réponse 13 est une courbe symétrique, ce qui se conçoit aisément puisque au cours d'une rotation de 180° le réseau présente deux positions symétriques par rapport au champ. La bande de fréquence de l'oscillateur est obtenue, comme cela a été exposé au sujet de la figure 2, en décalant les résonances des deux billes de Yig l'une par rapport à l'autre. Ainsi, si une première bille a une fréquence de résonance réglée sur un point 11, l'autre bille doit avoir une fréquence de résonance réglée sur le point complémentaire 12, ce qui donne un intervalle de fréquence ΔF.

Cet intervalle de fréquence ΔF entre les deux billes de Yig est surtout nécessaire vers les fréquences inférieures, de l'ordre de 6 à 10 GHz. Plus la fréquence d'oscillations devient élevée et plus cet intervalle peut être petit. De la sorte lorsque, par rotation appropriée des billes de Yig dans le champ magnétique H, on diminue ΔF entre les deux résonateurs, on supprime la partie de bande vers les fréquences inférieures, sans altérer les fréquences supérieures. Par conséquent dans la configuration de la figure 1, un oscillateur a deux billes de Yig nécessite un grand intervalle de fréquence de résonance entre les deux billes pour avoir une réponse en bande de fréquence qui soit étendue.

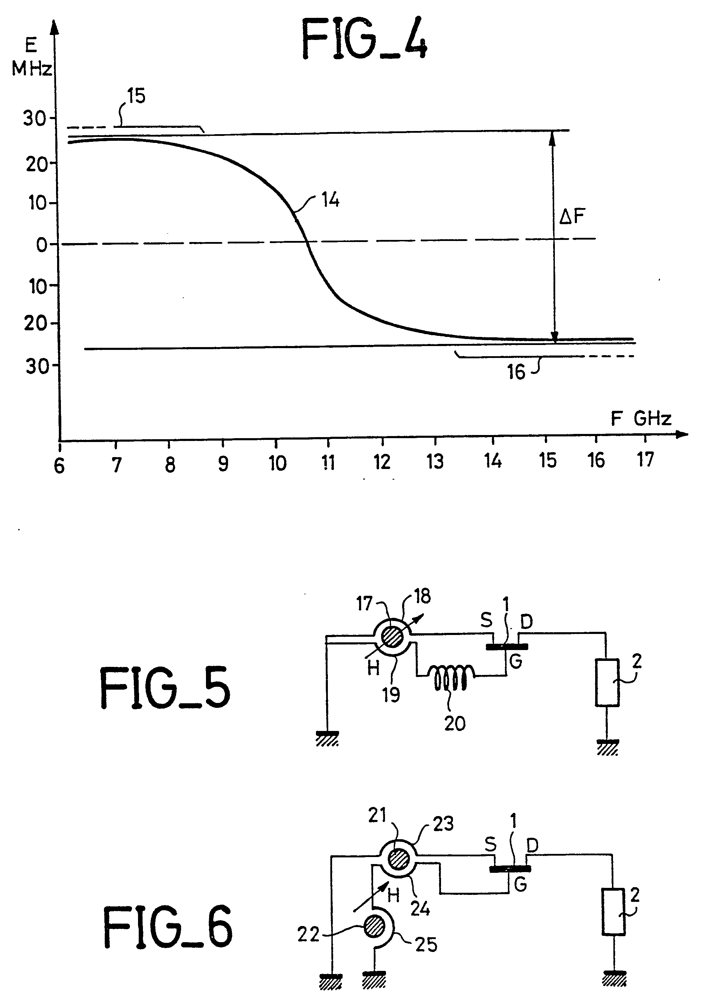

Mais par ailleurs la courbe de linéarité de l'oscillateur est une fonction de cet intervalle de fréquence de résonance ΔF entre les deux billes. C'est ce que représente la figure 4 qui montre le rôle de chaque résonateur dans un oscillateur à deux résonateurs. Cette figure donne en abscisse les fréquences de l'oscillateur, en GHz, et en ordonnée l'écart sur la linéarité, en MHz, c'est-à-dire l'écart entre l'intensité de commande du champ magnétique H et la réponse donnée par l'oscillateur, sa fréquence de sortie.

Les deux billes de Yig étant de même nature, suivent la même loi de linéarité parce qu'elles sont dans le même électro-aimant, mais du fait qu'elles sont décalées en fréquence de résonance les deux droites sont translatées l'une par rapport à l'autre de ΔF. Admettons que la droite supérieure corresponde à la loi de linéarité de la bille dite de source, c'est-à-dire la bille de Yig couplée à la source du transistor, et que la droite inférieure corresponde à la loi de linéarité de la bille dite de grille, c'est-à-dire la bille de Yig couplée à la grille de ce même transistor. L'ensemble de la figure 4 peut d'ailleurs être symétrisé par rapport à la ligne pointillée correspondant à un écart 0 c'est-à-dire pour lequel la linéarité est absolument parfaite.

Pour un oscillateur à deux billes de Yig, correspondant à un décalage ΔF entre les fréquences de résonance des deux billes de Yig, on constate que la courbe de linéarité 14 de cet oscillateur suit la loi de linéarité de la bille de source, dans la région 15, vers les fréquences inférieures et que, au fur et à mesure que la fréquence s'élève, cette courbe de linéarité de l'oscillateur suit la loi de linéarité de la bille de grille vers les fréquences supérieures dans la région 16. En d'autres termes, c'est la bille de source qui pilote la linéarité de l'oscillateur vers les fréquences inférieures et la bille de grille qui pilote la linéarité de l'oscillateur vers les fréquences supérieures.

Ou encore : vers les fréquences inférieures, c'est la bille de grille qui déstabilise le transistor, pour le rendre oscillant, et c'est la bille de source qui pilote la fréquence de l'oscillateur. Vers les fréquences supérieures, le rôle des deux billes est inversé, la bille de grille pilote la fréquence tandis que la bille de source déstabilise le transistor.

En conclusion un oscillateur comportant deux billes de Yig dans la configuration de la figure 1 est un oscillateur qui peut disposer d'une bande de fréquence relativement large, jusque deux octaves, mais qui n'a qu'une linéarité ΔF/F médiocre, de l'ordre de $10^{-2}$ en relatif.

La linéarité d'un oscillateur peut être améliorée lorsqu'il a la configuration de la figure 5, qui correspond à un oscillateur à une seule bille de Yig étudié par la Demanderesse.

Cet oscillateur comporte un transistor à effet de champ 1, dont le drain est chargé par une impédance 2, qui est par exemple normalisée à 50 ohms. Sa source est réunie à un dipôle d'accord constitué par une bille de Yig 17 couplée à la source par une demi boucle de fil 18. Sa grille est réunie à un dipôle de réaction constitué en partie par la même bille de Yig 17 couplée par une demi boucle de fil 19, en série avec une self 20, relativement importante compte tenu des fréquences considérées.

L'accord se faisant sur un seul résonateur, c'est-à-dire une seule bille de Yig doublement couplée, la réponse en fréquence en fonction du champ H est linéaire. La fréquence d'oscillation se fait légèrement avant la fréquence de résonance du Yig, sur la partie selfique de la courbe de réactance, telle qu'elle est représentée en L1, L2 en figure 2. Lorsque la fréquence de résonance augmente, le point d'oscillation descend le long de cette courbe selfique jusqu'à une valeur minimale qui est déterminée par la valeur de la self 20 de grille du transistor. Par conséquent la fréquence supérieure d'oscillation est déterminée par cette self mais, si l'on diminue cette self, on relève la fréquence inférieure d'oscillation d'où une limitation de la bande de fréquence de fonctionnement de l'oscillateur.

La figure 6 représente un schéma électrique simplifié de l'oscillateur selon l'invention qui tient compte de l'expérience acquise par l'oscillateur à deux billes de Yig, qui a une large bande de fréquence mais une linéarité médiocre et de l'oscillateur à une seule bille de Yig qui a une bande de fréquence limitée mais une bonne linéarité.

L'oscillateur selon l'invention comporte deux billes de Yig 21 et 22, couplées à la source et à la grille du transistor à effet de champ 1, chargé sur son drain par une impédance 2. La bille 21 est doublement couplée, c'est-à-dire qu'elle est par une demi boucle de fil 23 couplée à la source, ce qui en fait une réactance d'accord, et elle est par une demi boucle de fil 24 couplée à la grille, ce qui la fait entrer dans le circuit de réaction. La bille 22 est couplée par une demi boucle de fil 25 à la grille du transistor à effet de champ, mais ce dernier fil 25 est le même que celui qui déjà couple la bille 21 par une demi boucle de fil 24.

En résumé l'une des deux billes, la bille 21 est doublement couplée par deux fils 23 et 24 respectivement à la source et à la grille du transistor à effet de champ. Mais l'un des deux fils de câblage de l'oscillateur est doublement couplé en 24 et en 25 aux deux billes de Yig 21 et 22 respectivement.

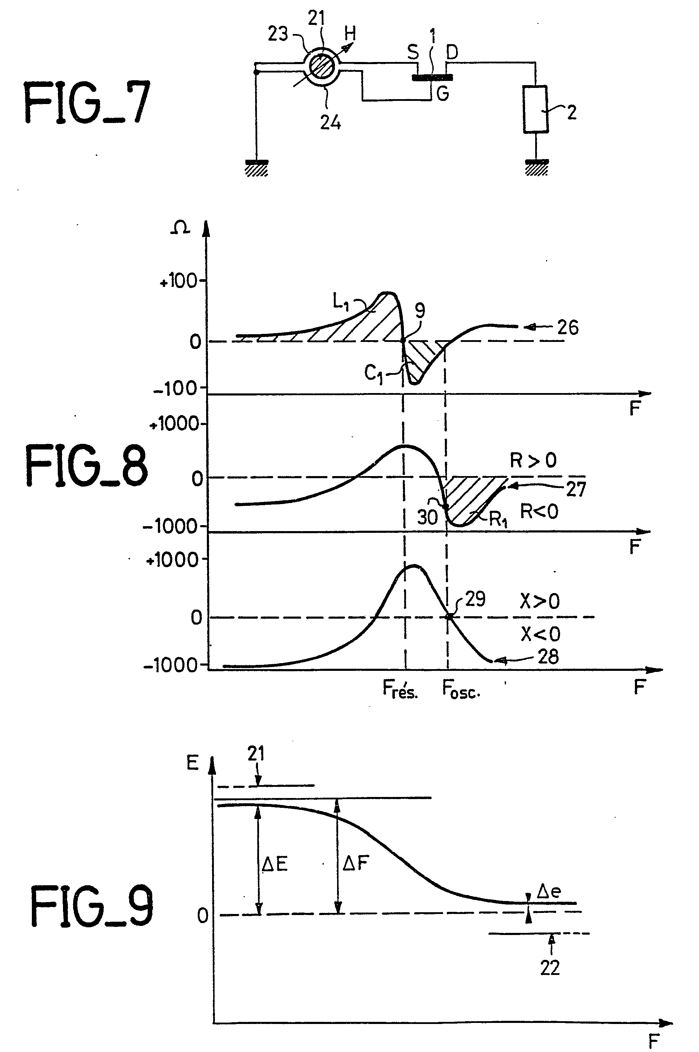

L'analyse du fonctionnement de cet oscillateur selon l'invention sera facilitée par l'étude du fonctionnement de la seule bille 21, dans le schéma représenté en figure 7. Sur cette figure 7, on reconnait immédiatement, par comparaison avec la figure 6, que la seconde bille, 22 est supprimée et que par conséquent son influence sur le fonctionnement de l'oscillateur n'intervient pas.

La figure 8 représente les courbes d'impédances du résonateur doublement couplé, c'est-à-dire la bille de Yig 21 de la figure 7.

En abscisse de la figure 8 sont données les fréquences et en ordonnées les impédances, c'est-à-dire selon les courbes la réactance ou la résistance, le détail en étant précisé ultérieurement.

La courbe supérieure, 26, de la figure 8 représente la réactance de la bille de Yig 21 conformément à ce qui a été exposé en figure 2. Cette bille de Yig a une réactance positive et selfique représentée par la partie L1 de courbe supérieure à 0 et une partie capacitive C1, inférieure à 0 qui correspond donc à une résistance négative. Le point 9 auquel cette courbe 26 passe par une réactance nulle correspond à la fréquence de résonance de la bille de Yig.

La courbe médiane, repérée 27, est la courbe de résistance ramenée sur le drain D du transistor à effet de champ 1 par la bille de Yig. Cette courbe de résistance a une partie négative, puis une partie positive et enfin un point de rebroussement avec à nouveau une partie négative notée R1, lorsque la fréquence augmente.

Enfin la courbe inférieure notée 28 représente la courbe de réactance X ramenée sur le drain D du transistor à effet de champ 1 par la bille de Yig 21 doublement couplée.

On se rappelle qu'une condition pour qu'un dispositif oscille est que la somme des résistances soit négative et que la somme des réactances soit nulle. La courbe 28 représentant la réactance ramenée sur le drain s'annule deux fois mais il n'y a qu'en un seul point 29 que la somme des réactances X étant nulle correspond à la somme des résistances R1 négatives au point 30, ce qui correspond en outre à une réactance négative de la bille de Yig sur la courbe 26.

Par conséquent, avec une bille doublement couplée comme en figure 7, l'accord se fait après la résonance de la bille, mais cette bille doublement couplée amène une résistance négative sans qu'il soit utile de disposer une grosse self dans le circuit de grille comme cela était le cas figure 5.

Donc la bille doublement couplée joue le même rôle que la bille dite de source, mais elle génère une résistance négative plus bas en fréquence.

Pour en revenir à la figure 6, la bille 21 joue donc le rôle de bille de source, et c'est elle qui pilote les fréquences de l'oscillateur dans le domaine des fréquences inférieures, tandis que la bille 22 joue le rôle de bille de grille et c'est elle qui pilote les fréquences de l'oscillateur dans le domaine des fréquences supérieures.

La figure 9 représente la courbe d'écart de linéarité de l'oscillateur selon l'invention. Cette figure 9 ressemble à celle de la figure 4, mais les échelles n'y sont pas les mêmes puisque c'est un objectif de l'invention.

Il a été dit précédemment que, pour obtenir une large bande, il faut un grand ΔF. Plus on augmente ΔF, c'est-à-dire l'intervalle de résonance entre les deux billes, et plus on descend en fréquence, mais moins bonne est la linéarité.

Sur la figure 9, la droite de loi linéaire de la bille de grille, c'est-à-dire la bille 22, est prise comme droite de référence des écarts de linéarité de l'oscillateur. Aux fréquences supérieures, c'est la bille de grille 22 qui pilote l'oscillateur et impose la fréquence : l'écart Δe sur la linéarité est très faible. Aux fréquences inférieures, c'est la bille de source, c'est-à-dire la bille doublement couplée 21, qui pilote l'oscillateur. Mais, d'une part, cette bille génère une résistance négative plus bas en fréquence, et donc elle élargit la bande de fréquence, et d'autre part, étant donné qu'aux fréquences inférieures, c'est elle seule qui pilote l'oscillateur et qu'elle est doublement couplée, elle apporte à l'oscillateur une bonne linéarité dans la gamme des fréquences inférieures, qui est plus étendue que dans un oscillateur à une ou deux billes, selon l'art connu.

L'intervalle ΔF, entre les fréquences de résonances des deux billes 21 et 22, est important, et il permet d'étendre la bande de fréquences, mais cependant l'écart de linéarité ΔE, dans les fréquences inférieures, reste très faible.

A titre d'exemple, alors que l'oscillateur selon l'art connu de la figure 1 avait une bande de fréquence allant de 4 à 22 GHz et une linéarité de $10^{-2}$, soit ± 50 MHz à 10 GHz, l'oscillateur selon l'invention, de la figure 6, a une bande de fréquence allant de 4 à 22 GHz, et un écart de linéarité de ± 10 Mhz.

IL est évident que l'invention qui a été décrite en s'appuyant sur un transistor à effet de champ peut être appliquée à d'autres dispositifs semiconducteurs de type tri-porte, et que les billes de Yig peuvent être remplacées par des billes de GaYig, ou par des résonateurs gyromagnétiques, sans sortir du domaine de l'invention.

L'oscillateur selon l'invention est utilisé dans les matériels hyperfréquences.

**Revendications**

1. Oscillateur à très hautes fréquences, comportant un transistor à effet de champ (1), dont la source (S) est réunie à un premier dipôle à résonateur gyromagnétique (21), la grille (G) est réunie à un second dipôle à résonateur gyromagnétique (22) et le drain (D) est réuni à une impédance de charge (2), les deux résonateurs gyromagnétiques (21-22) étant réglables simultanément par un même moyen électrique, cet oscillateur étant caractérisé en ce que :
   - le premier résonateur (21) est doublement couplé (en 23) par un premier conducteur électrique connecté à la source (S) du transistor (1) et (en 24) par un second conducteur électrique connecté à la grille (G) du transistor (1),
   - ledit second conducteur électrique est en outre doublement couplé (en 25) au second résonateur (22).

2. Oscillateur selon la revendication 1, caractérisé en ce que l'un au moins des résonateurs gyromagnétiques (21, 22) est une sphère de matériau magnétique monocristallin.

3. Oscillateur selon la revendication 2, caractérisé en ce que le matériau magnétique monocristallin est un grenat d'yttrium-fer Yig ou un grenat de gallium-yttrium-fer GaYig.

4. Oscillateur selon la revendication 1, caractérisé en ce que le premier résonateur (21), doublement couplé (en 23 et 24), constitue le résonateur de source de l'oscillateur, lequel suit, dans la bande inférieure des fréquences, la loi de fréquences et de linéarité dudit premier résonateur (21).

5. Oscillateur selon la revendication 1, caractérisé en ce que le second résonateur (22), couplé (en 25) à la grille (G), constitue le résonateur de grille de l'oscillateur, lequel suit, dans la bande supérieure des fréquences, la loi de fréquences et de linéarité dudit second résonateur (22).

6. Oscillateur selon la revendication 1, caractérisé en ce que les deux résonateurs (21, 22) sont couplés (en 23, 24, 25) au transistor (1) au moyen de demi-boucles de fil conducteur, contournant les sphères de matériau gyromagnétique.

### Claims

1. A very high frequency oscillator, comprising a field effect transistor (1), the source (S) of which is linked to a first gyromagnetic resonator dipole (21), the gate (G) of which is linked to a second gyromagnetic resonator dipole (22) and the drain (D) is linked to a load impedance (2), the two gyromagnetic resonators (21-22) being simultaneously adjustable by the same electric means, this oscillator being characterized in that :
- the first resonator (21) is coupled twice, namely (at 23) by means of a first electric conductor connected to the source (S) of the transistor (1), and (at 24) by means of a second electric conductor to the gate (G) of the transistor (1),
- said second electric conductor is coupled twice (at 25) to the second resonator.

2. An oscillator according to claim 1, characterized in that at least one of the gyromagnetic resonators (21, 22) is a sphere made up of a monocrystalline magnetic material.

3. An oscillator according to claim 2, characterized in that the monocrystalline magnetic material is an Yttrium-iron garnet Yig or a Gallium-Yttrium-iron garnet GaYig.

4. An oscillator according to claim 1, characterized in that the first resonator (21), coupled twice (at 23 and 24), constitutes the source resonator of the oscillator, which obeys, within the lower frequency band, the law of the frequencies and of the linearity of said first resonator (21).

5. An oscillator according to claim 1, characterized in that the second resonator (22), coupled (at 25) to the gate (G) constitutes the gate oscillator, which obeys, within the upper frequency band, the law of the frequencies and of linearity of said second resonator (22).

6. An oscillator according to claim 1, characterized in that the resonators (21, 22) are coupled (at 23, 24, 25) to the transistor (1) through half-turns of a conductor wire, surrounding the spheres of gyromagnetic material.

### Patentansprüche

1. Oszillator sehr hoher Frequenz, mit einem Feldeffekttransistor (1), dessen Source (S) an einen ersten gyromagnetischen Resonatordipol (21), dessen Gate (G) an einen zweiten gyromagnetischen Resonatordipol (22) und dessen Drain (D) an eine Lastimpedanz (2) angeschlossen ist, wobei die beiden gyromagnetischen Resonatoren (21-22) gleichzeitig durch ein gleiches elektrisches Mittel einstellbar sind, dadurch gekennzeichnet, daß:
- der erste Resonator (21) doppelt gekoppelt ist, nämlich (bei 23) durch einen ersten, an die Source (S) des Transistors (1) angeschlossenen, elektrischen Leiter und (bei 24) durch einen zweiten, an das Gate (G) des Transistors (1) angeschlossenen elektrischen Leiter,
- wobei der zweite elektrische Leiter weiter doppelt (bei 25) an den zweiten Resonator (22) angekoppelt ist.

2. Oszillator nach Anspruch 1, dadurch gekennzeichnet, daß mindestens einer der gyromagnetischen Resonatoren (21, 22) eine Kugel aus monokristallinem, magnetischem Material ist.

3. Oszillator nach Anspruch 2, dadurch gekennzeichnet, daß das monokristalline, magnetische Material ein Yttrium-Eisen-Granat Yig oder ein Gallium-Yttrium-Eisen-Grant GaYig ist.

4. Oszillator nach Anspruch 1, dadurch gekennzeichnet, daß der erste doppelt (bei 23 und 24) angekoppelte Resonator (21) den Sourcenresonator des Oszillators bildet, der im unteren Frequenzband dem Frequenzgesetz und dem Linearitätsgesetz des ersten Resonators (21) folgt.

5. Oszillator nach Anspruch 1, dadurch gekennzeichnet, daß der zweite (bei 25) an das Gate (G) angekoppelte Resonator (22) den Gateresonator des Oszillators bildet, der im oberen Frequenzband dem Frequenzgesetz und dem Linearitätsgesetz des zweiten Resonators (22) folgt.

6. Oszillator nach Anspruch 1, dadurch gekennzeichnet, daß die beiden Resonatoren (21, 22) an den Transistor (1) mithilfe von Halbschleifen von Leiterdraht (bei 23, 24, 25) angekoppelt sind, die um die Kugeln aus gyromagnetischem Material herumgeführt sind.

FIG_1

FIG_2

FIG_3

# FIG_4

# FIG_5

# FIG_6

FIG_7

FIG_8

FIG_9